# EUROPEAN PATENT SPECIFICATION

(11) **EP 0 950 924 B1**
(45) Date of publication and mention of the grant of the patent: **08.11.2006**
(21) Application number: 99302740.8
(22) Date of filing: 08.04.1999
(51) Int. Cl.: G03F 7/20

(54) **Lithographic projection apparatus and device manufacturing method**
Lithograpischer Projektionsapparat und Verfahren zur Herstellung einer Vorrichtung
Appareil de projection lithographique et méthode de fabrication d'un dispositif

(30) Priority: 14.04.1998 EP 98201172
(43) Date of publication of application: 20.10.1999
(73) Proprietor: ASML Netherlands B.V., 5504 DR Veldhoven (NL)
(72) Inventor: Van der Lei, Sijbe Abraham Hartman, 5501 DV Veldhoven (NL); De Leeuw, Rard Willem, 5643 PX Eindhoven (NL); Bonnema, Gerrit Maarten, 5654 AH Eindhoven (NL); Corbeij, Wilhelmus Maria, 5646 JK Eindhoven (NL)
(74) Representative: Leeming, John Gerard

(56) References cited:
- EP-A- 0 833 209
- US-A- 5 473 410
- US-A- 5 663 784

## Description

The present invention relates to dose control in lithographic projection apparatus comprising:
a radiation system for supplying a projection beam of radiation;
a first object table movable in at least a first direction, the scan direction, and provided with a mask holder for holding a mask having a mask pattern;
a second object table movable in the first direction and provided with a substrate holder for holding a substrate; and
a projection system for imaging an irradiated portion of the mask onto a target portion of the substrate with a magnification M.

For the sake of simplicity, the projection system may hereinafter be referred to as the "lens"; however, this term should be broadly interpreted as encompassing various types of projection system, including refractive optics, reflective optics and catadioptric systems, for example. The radiation system may also include elements operating according to any of these principles for directing, shaping or controlling the projection beam of radiation and such elements may also be referred to below, collectively or singularly, as a "lens". Any refractive, reflective or catadioptric elements in the radiation or illumination systems may be based on a substrate of glass or another suitable material, and may be provided with either single- or multi-layer coatings as desired. In addition, the first and second object tables may be referred to as the "mask table" and the "substrate table", respectively. Further, the lithographic apparatus may be of a type having two or more mask tables and/or two or more substrate tables. In such "multiple stage" devices the additional tables may be used in parallel or preparatory steps may be carried out on one or more stages while one or more other stages are being used for exposures. Twin stage lithographic apparatus are described in International Patent Applications WO 98/28665 and WO 98/40791.

Lithographic projection apparatus can be used, for example, in the manufacture of integrated circuits (ICs). In such a case, the mask (reticle) may contain a circuit pattern corresponding to an individual layer of the IC, and this pattern can then be imaged onto a target area (die) on a substrate (silicon wafer) which has been coated with a layer of photosensitive material (resist). In general, a single wafer will contain a whole network of adjacent dies which are successively irradiated through the reticle, one at a time. In one type of lithographic projection apparatus, each die is irradiated by exposing the entire reticle pattern onto the die in one go; such an apparatus is commonly referred to as a wafer stepper. In an alternative apparatus -- which is commonly referred to as a step-and-scan apparatus -- each die is irradiated by progressively scanning the reticle pattern under the projection beam in a given reference direction (the "scanning" direction) while synchronously scanning the wafer table parallel or anti-parallel to this direction; since, in general, the projection system will have a magnification factor M < 1, the speed v at which the wafer table is scanned will be a factor M times that at which the reticle table is scanned. More information with regard to lithographic devices as here described can be gleaned from International Patent Application WO 97/33205.

A step-and-scan exposure apparatus is described in WO 97/33204. In this apparatus, reticle masking blades are used to define a slit through which an illumination beam passes to illuminate a rectangular portion of a reticle, an image of which is projected onto a wafer with a magnification M. The reticle is moved so that the illuminated portion scans the whole pattern to be imaged. The wafer is moved synchronously at a speed M times that of the reticle in the opposite direction to the reticle so that the whole pattern is imaged onto the wafer. At the end of a scan the wafer is stepped to the beginning of the next field to be illuminated, and the illumination process is repeated.

It is important to ensure that the entire field is properly and uniformly illuminated. This requires that the slit, defined by the reticle masking blades, is constantly and uniformly illuminated throughout the scan. Control of the exposure in a scanning exposure system has therefore been a problem.

US 5,473,410 and US 5,663,784 disclose lithographic apparatus in accordance with the pre-characterizing portion of claim 1.

It is an object of the present invention to provide a lithography apparatus having improved control over the field illumination uniformity.

According to the present invention, this and other objects are achieved in a lithographic projection apparatus comprising:
a radiation system for supplying a projection beam of radiation onto a mask having a pattern said radiation system being adapted to supply a projection beam whose cross-section in the plane of the mask is smaller than the mask pattern, the radiation system including movable beam masking means for controlling the cross-section of the projection beam;
a first object table movable in at least a first direction and provided with a substrate holder for holding the mask having the mask pattern;
a second object table movable in the first direction and provided with a substrate holder for holding a substrate;
a projection system for imaging an irradiated portion of the mask onto a target portion of the substrate with a magnification M; and
control means for causing the beam masking means to be closed prior to, and open at, the beginning of a scan; characterized by:
   compensation means for compensating for a variation in radiation intensity of the projection beam on the mask whilst the beam masking means are opening.

The present inventors have determined that exposure (dose) errors occur at the beginning and end of the scan and are caused by reflections from the reticle masking blades. The present invention therefore provides means for compensating for the increased illumination as the slit defined by the beam masking means (e.g. reticle masking blades) is opened and closed. The present invention enables the slit illumination to be controlled so as to be constant and uniform throughout the scan, thus improving the consistency and yield of an IC manufacturing process employing the inventive apparatus.

Preferably said compensation means comprise radiation source control means adapted to control the output of the radiation source (e.g. lamp), which is employed to produce the illumination beam, in accordance with the degree of opening of the beam masking means, to compensate for said variation.

More preferably, said radiation source control means are adapted to control the radiation source output according to a function determined by the cross-section of the projection beam when the beam masking means are fully open and the size of the reticle pattern to be imaged. Said function may be calculated from empirically derived reference values. The present invention also encompasses a device manufacturing method according to claim 14.

Alternatively or in addition, said compensating means may be such that the beam masking means are constructed of a material substantially transparent to said illumination beam and are shaped so that portions of said illumination beam incident thereon are totally internally reflected.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target area", respectively.

In a manufacturing process using a lithographic projection apparatus according to the invention a pattern in a mask is imaged onto a substrate which is at least partially covered by a layer of energy-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer of may then undergo various processes such as etching, ion-implantation (doping) metallisation, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

The present invention and its attendant advantages will be described below with reference to exemplary embodiments and the accompanying schematic drawings, in which:
Fig. 1 depicts a lithographic projection apparatus according to a first embodiment of the invention;
Fig. 2 is a diagram of the illumination optics of a scanning illumination system according to the invention;
Fig. 3 is a cross-sectional view of part of a reticle masking blade employed as beam masking means in an embodiment of the invention; and
Figs. 4 to 6 are graphs illustrating lamp output control modes of the invention.

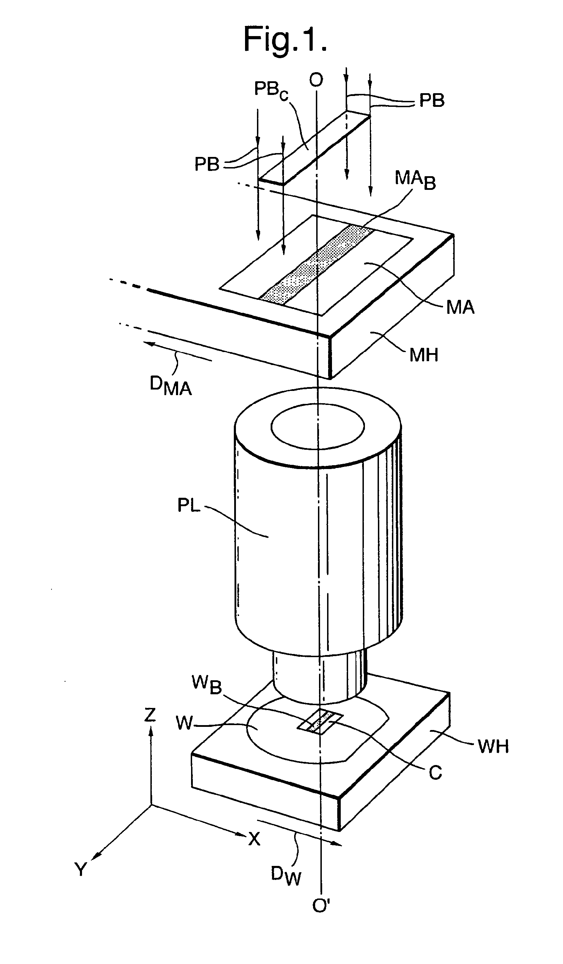

In the Figures, like parts are indicated by like reference numerals.
The principle of a step-and-scan illumination system according to a first embodiment of the invention is shown in Figure 1 of the accompanying drawings. This Figure shows a demagnified image of the mask MA formed on the substrate W mounted on table WH in a step-and-scan apparatus; the magnification M of the projection lens system is, for example, 1/4. The projection beam PB is partially obstructed by reticle masking blades (not shown) so as to have, at the area of the mask, for example, a rectangular cross-section PB_{c} so that a rectangular part MA_{B} of this mask is illuminated. This part is imaged by the projection lens system PL on a similarly rectangular part W_{B} of the substrate W. By moving the mask with respect to the substrate synchronously in opposite X directions, as is shown by way of the arrows D_{MA} and D_{w} in Fig. 1, and by taking the magnification M into account, the entire mask is successively illuminated and the entire mask pattern is imaged on an area C of the substrate. The mask and the substrate may also be moved in the same X direction.

After the mask pattern has been imaged on a first Integrated Circuit (IC) area (i.e. target area), the substrate holder is moved with respect to the mask along a distance which is equal to the period of the IC areas in the X direction or the Y direction, and the mask is imaged on a second IC area (i.e. target area) by the scanning radiation pattern PB_{c}.

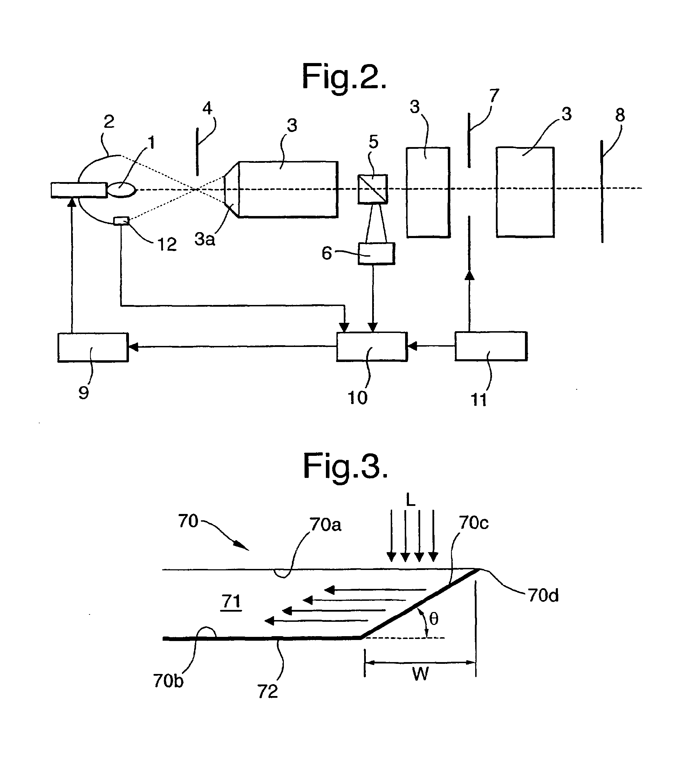

The relevant components of an illumination system of a lithographic apparatus according to the present invention are shown schematically in Figure 2. Light emitted by radiation source 1, e.g. a mercury lamp, is collected by elliptical mirror 2 and reflected into the first element 3a of the illumination optical system 3 which projects the light onto the reticle 8; the radiation source may also be a laser. Such a radiation source may emit UV light having a wavelength of 365nm, 248nm, 193nm or 157nm, for example. A shutter 4 is provided between the lamp 1 and the illumination optical system 3. At a convenient point in the illumination optical system, a portion of the illumination light is diverted by a beam splitter 5 to energy sensor 6 to enable monitoring of the amount of optical energy reaching the reticle 8. The actual dimensions of the scanning radiation pattern are determined by reticle masking means 7 which define a slit through which the reticle is illuminated. The remaining components of the device are omitted for clarity but may be as illustrated in Figure 1.

At the beginning of the scan of a field the reticle masking blades, which comprise the reticle masking means 7, are closed. As the scan begins, the leading blade in the scan direction moves to open the slit, the slit is then scanned over the field and at the end of the scan the following blade is moved to close the slit.

In a first embodiment of the invention, the lamp intensity is reduced when the slit is closed and increased in synchronism with the opening of the slit.

Specifically it has been determined that the illumination intensity is a linear function of the fraction, X, of the cross-section of the slit which at a given time is obscured (i.e. the open fraction is 1-X, and X=0 when the slit is fully open). Accordingly, the system comprises a lamp control circuit 10 which controls the lamp power supply 9 so that the lamp intensity follows a reciprocal linear function of X to ensure that the radiation intensity at wafer level is constant.

Data indicating the slit cross-section are provided to the lamp control circuit 10 by the reticle masking servo control 11.

The illumination intensity variation as a function of X differs for different combinations of slit cross-section and die size and therefore needs to be adjusted for each manufacturing sequence. The function may be measured each time. Alternatively, it may be measured in advance for a plurality of slit and die combinations and the relevant function for a given manufacturing run modeled from these reference functions.

In a second embodiment of the invention, the reticle masking blades are constructed to avoid reflecting the illumination light.

As shown in Figure 3 the reticle masking blade 70 has a main body 71 constructed of quartz. The front face 70a of the blade 70, on which the illumination light L is incident, is flat. The rear face 70b has an inclined portion 70c so that the blade is thinnest at its edge 70d. The angle θ of the inclined face 70c is set such that the illumination light incident on the front face 70a is totally internally reflected and directed sideways, out of the illumination beam, to an absorber. The front face 70a may be coated with an anti-reflection coating optimized for the illumination light frequency.

If so desired, the rear face of the blade 70 may be coated with a reflective metallic layer 72 (e.g. comprised of aluminum). The angle θ then no longer has to be chosen so that all light incident on the front face 70a undergoes total internal refection at the face 70c (since now conventional reflection will occur at the metallic layer 72).

Reflections from the reticle masking blades are thereby eliminated and the intensity density of the illumination light is made constant throughout the opening of the blades.

An alternative method proposed by the invention to compensate for the increase in intensity density of the illumination light is to control the scan speed. As mentioned above, the intensity density is a linear function of X. This can be compensated for by a linearly increasing scan speed. Since the scan speed is proportional to the slit cross-section and illumination intensity, but inversely proportional to the dose, it can be seen that the dose will be constant as a function of X. The reticle table and reticle masking blades must be controlled to move correspondingly with the scan speed defined above.

In this embodiment of the present invention the energy sensor 6 is positioned downstream of the shutter 4 because it is desired to place it as close to the reticle as possible to take account of the effect of as much of the illumination optical system as possible. This closed loop feedback control is advantageous when the shutter is open. However, when the shutter is closed no light reaches the sensor and it is therefore not possible to control the lamp on the basis of this sensor.

The present invention therefore provides an additional control system for use when the shutter is closed. This additional control loop may comprise a current control loop which provides open loop control of the lamp brightness through closed loop control of the current flowing through it. Alternatively an additional lamp sensor 12 is provided upstream of the shutter to detect the brightness of the lamp directly. A signal from the lamp sensor is fed to the lamp control circuit 10 which stabilizes the light flux.

It is necessary to control the switch over from control of the lamp by the lamp sensor 12 to control by the light sensor 6. The present invention provides three options for this.

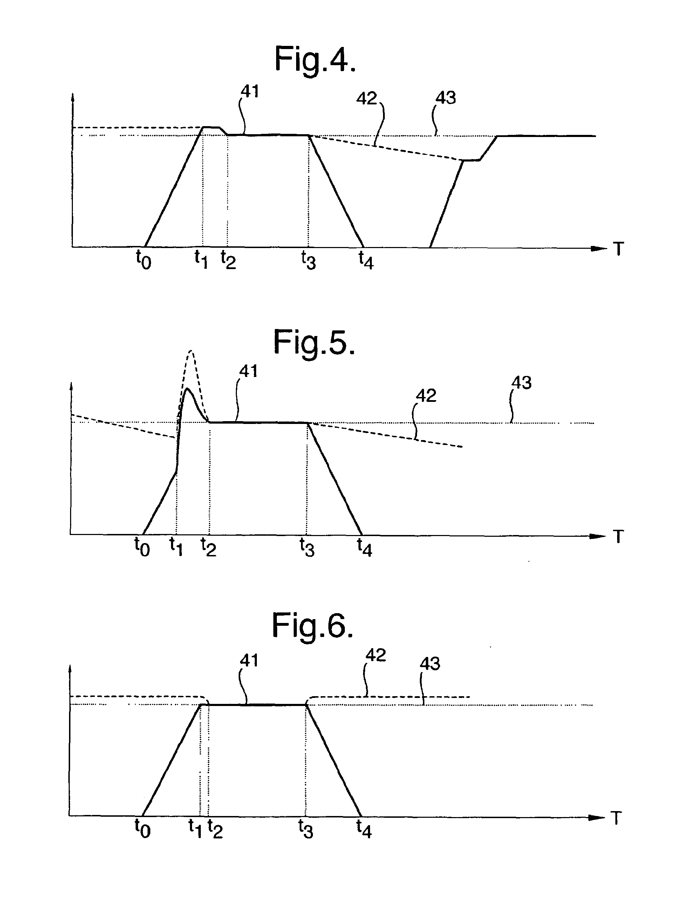

Firstly, the shutter 4 is fully opened and the light sensor 6 and lamp 1 allowed to settle to the appropriate level under control of the light sensor 6 before the reticle masking blades 7 are opened and the scan begins. This method is very reliable but has a potential disadvantage in that throughput will be reduced if the lamp settling time is longer than the substrate table settling time. This control process is illustrated in Figure 4. At time t₀ the shutter opens and the energy detected by the light sensor 6, shown by solid line 41, rises to the level of the actual lamp output, shown by dashed line 42. At time t₁ when the shutter is fully open, the measured energy equals the actual lamp energy. The sensor is allowed to settle and the lamp output adjusted to the desired level, shown by dotted line 43. The exposure begins at t₂ and ends at t₃ during which time the lamp output is controlled on the basis of the lamp sensor 6. At the end of the exposure the lamp sensor signal falls off as the shutter closes until it reaches zero at t₄ when the shutter is fully closed.

An alternative control strategy makes use of the known properties of the lamp control system and the known shutter opening time, e.g. 10 ms. This process is illustrated in Figure 5. If control is switched to the light sensor 6 at time t₁, perhaps halfway through the shutter opening, the light sensor control will cause a large overshoot in the lamp power because the light sensor is only sensing half of its output. Because the light sensor control loop has a very fast response time, the lamp power will be brought quickly to the correct level by the time the exposure begins at t₂. Proper selection of the timing of changeover of control will ensure that the lamp is at the correct level most rapidly.

The third alternative is to operate both control loops simultaneously with the lamp power being controlled on the basis of the lower of the two controls and the set point for the shutter closed (i.e. lamp sensor) control loop set slightly higher than the desired energy level. This is shown in Figure 6. When the shutter is closed the light sensor 6 control loop will command a very high lamp output so that control will follow the shutter closed control loop. As the shutter opens, beginning at t₀, the output level commanded by light sensor 6 will fall until t₁ when it drops below the shutter closed set point and the light sensor control takes over. The lamp output will fall quickly to the desired level and exposure can begin at t₂. When the shutter begins to close at t₃, the lamp output will rise as the light sensor 6 commands an increase in output to compensate for the reduction in light reaching it. Very soon however, the output commanded by the light sensor 6 will rise above the shutter closed set point and that control will therefore takeover. In this way switching between control loops is automatic.

## Claims

1. A lithographic projection apparatus comprising:
a radiation system (2, 3) for supplying a projection beam (PB) of radiation onto a mask (MA) having a pattern said radiation system being adapted to supply a projection beam whose cross-section in the plane of the mask is smaller than the mask pattern, the radiation system including movable beam masking means (7) for controlling the cross-section of the projection beam;
a first object table movable in at least a first direction and provided with a substrate holder (MH) for holding the mask having the mask pattern;
a second object table movable in the first direction and provided with a substrate holder (WH) for holding a substrate;
a projection system (PL) for imaging an irradiated portion of the mask onto a target portion of the substrate with a magnification M; and
control means (11) for causing the beam masking means to be closed prior to, and open at, the beginning of a scan; **characterized by**:
compensation means (10, 9) for compensating for a variation in radiation intensity of the projection beam on the mask whilst the beam masking means are opening.

2. A lithographic projection apparatus according to claim 1 wherein said compensation means comprises radiation source control means (10, 9) adapted to control the output of a radiation source (1) used to produce the projection beam, in accordance with the degree of opening of the beam masking means (7), to compensate for said variation.

3. A lithographic projection apparatus according to claim 2 wherein said variation is an increase and said radiation source control means (10, 9) are adapted to reduce the radiation source output while the beam masking means (7) are opening.

4. A lithographic projection apparatus according to claim 3 wherein said radiation source control means (10, 9) are adapted to control the radiation source output to follow a reciprocal linear function of X, where X is the obscured proportion of the cross-section of a slit defined by the beam masking means (7).

5. A lithographic projection apparatus according to claim 2, 3 or 4 wherein said radiation source control means (10, 9) are adapted to control the radiation source output according to a function determined by:
the cross-section of the projection beam when the beam masking means (7) are fully open and
the size of the reticle pattern to be imaged.

6. A lithographic projection apparatus according to claim 5 wherein said function is calculated from empirically derived reference values.

7. A lithographic projection apparatus according to any one of the preceding claims wherein said compensating means are that the beam masking means (70) are constructed of a material substantially transparent to said projection beam and are embodied such that portions of said projection beam incident thereon undergo total internal reflection.

8. A lithographic projection apparatus according to any one of the preceding claims wherein said compensating means comprises a reflective coating (72) provided on the rear surface of said beam masking means (70) relative to the direction of incidence of the projection beam.

9. A lithographic projection apparatus according to claim 8 wherein said rear surface of said beam masking means (70) includes an inclined portion (70C) adjacent to an edge (70D) thereof.

10. A lithographic projection apparatus according to claim 8 or 9 wherein said reflective coating (72) comprises aluminium.

11. A lithographic projection apparatus according to any one of claims 7 to 10 wherein said material substantially transparent to said projection beam comprises quartz or glass.

12. A lithographic projection apparatus according to any one of the preceding claims wherein said radiation system comprises a radiation source (1) and an illumination system (3) including beam-shaping optical elements, said beam masking means (7) comprising beam masking blades provided in, or downstream relative to the direction of propagation of said projection beam of, said illumination system.

13. A lithographic projection apparatus according to claim 12 further comprising a shutter (4) provided between said radiation source and said illumination system for selectively passing and blocking said projection beam.

14. A device manufacturing method comprising the steps of:
providing a substrate which is at least partially covered by a layer of energy-sensitive material;
providing a mask containing a pattern;
using a projection beam of radiation to project an image of at least part of the mask pattern onto a target area of the layer of energy-sensitive material with a magnification M;
moving the mask during said projection step in a scan direction relative to said projection beam; and
moving the substrate during said projection step along said scan direction at a rate equal to M times the rate at which the mask is moved; and
providing beam masking means that are closed prior to and opened at the beginning of said projection step; **characterized by**:
compensating for a variation in radiation intensity of the projection beam on the mask whilst the beam masking means are opening.

## Patentansprüche

1. Ein lithografischer Projektionsapparat, aufweisend:
ein Bestrahlungssystem (2, 3) zum Richten eines Projektionsstrahls (PB) einer Strahlung auf eine Maske (MA) mit einem Muster, wobei das Projektionssystem einen Projektionsstrahl zu liefern vermag, dessen Querschnitt in der Ebene der Maske kleiner ist als das Maskenmuster, wobei das Bestrahlungssystem bewegliche Strahlmaskierungsmittel (7) enthält, um den Querschnitt des Projektionsstrahls zu steuern;
einen ersten Objekttisch, der in wenigstens einer ersten Richtung beweglich ist und mit einem Substrathalter (MH) zum Halten der Maske versehen ist, die das Maskenmuster hat;
einen zweiten Objekttisch, der in die erste Richtung beweglich ist und mit einem Substrattisch (WH) zum Halten eines Substrats versehen ist;
einem Projektionssystem (PL) zum Abbilden eines bestrahlten Abschnitts auf der Maske auf einen Zielabschnitt des Substrats mit einer Vergrösserung M; und Steuermittel (11) zum Veranlassen, dass die Strahlmaskierungsmittel vor einer Abtastung geschlossen und zu deren Beginn geöffnet sind, **gekennzeichnet durch**:
Kompensationsmittel (10, 9) zur Kompensation von Änderungen in der Strahlungsintensität des Projektionsstrahls auf der Maske, während sich die Strahlmaskierungsmittel öffnen.

2. Ein lithografischer Projektionsapparat nach Anspruch 1, wobei die Kompensationsmittel Strahlungsquellensteuermittel (10, 9) aufweisen, welche den Ausgang einer Strahlungsquelle (1), welche zur Erzeugung des Projektionsstrahls verwendet wird, abhängig vom Öffnungsgrad der Strahlmaskierungsmittel (7) zu steuern vermögen, um die Änderung zu kompensieren.

3. Ein lithografischer Projektionsapparat nach Anspruch 2, wobei die Änderung ein Anstieg ist und die Strahlungsquellensteuermittel (10, 9) den Strahlungsquellenausgang zu verringern vermögen, während sich die Strahlmaskierungsmittel (7) öffnen.

4. Ein lithografischer Projektionsapparat nach Anspruch 3, wobei die Strahlungsquellensteuermittel (10, 9) den Strahlungsquellenausgang zu steuern vermögen, dass dieser einer reziproken linearen Funktion von X folgt, wobei X der abgedunkelte Anteil des Querschnitts eines Schlitzes ist, der von den Strahlmaskierungsmitteln (7) definiert wird.

5. Ein lithografischer Projektionsapparat nach Anspruch 2, 3 oder 4, wobei die Strahlungsquellensteuermittel (10, 9) den Strahlungsquellenausgang gemäss einer Funktion zu steuern vermögen, die bestimmt ist durch:
den Querschnitt des Projektionsstrahls, wenn die Strahlmaskierungsmittel voll offen sind, und
die Größe des abzubildenden Strichmusters.

6. Ein lithografischer Projektionsapparat nach Anspruch 5, wobei die Funktion aus empirisch erhaltenen Referenzwerten berechnet wird.

7. Ein lithografischer Projektionsapparat nach einem der vorhergehenden Ansprüche, wobei die Kompensationsmittel so sind, dass die Strahlmaskierungsmittel (70) aus einem Material gebildet sind, welches für den Projektionsstrahl im Wesentlichen transparent ist und so ausgebildet sind, dass Teile des hierauf fallenden Projektionsstrahls eine Innentotalreflektion erfahren.

8. Ein lithografischer Projektionsapparat nach einem der vorhergehenden Ansprüche, wobei die Kompensationsmittel eine reflektierende Beschichtung (72) aufweisen, die relativ zur Einfallsrichtung des Projektionsstrahls an der rückwärtigen Oberfläche der Strahlmaskierungsmittel (70) angeordnet ist.

9. Ein lithografischer Projektionsapparat nach Anspruch 8, wobei die rückwärtige Oberfläche der Strahlmaskierungsmittel (70) benachbart einer Kante (70D) hiervon einen geneigten Abschnitt (70C) aufweisen.

10. Ein lithografischer Projektionsapparat nach Anspruch 8 oder 9, wobei die reflektierende Beschichtung (72) Aluminium aufweist.

11. Ein lithografischer Projektionsapparat nach einem der Ansprüche 7 bis 10, wobei das für den Projektionsstrahl im Wesentlichen transparente Material Quarz oder Glas aufweist.

12. Ein lithografischer Projektionsapparat nach einem der vorhergehenden Ansprüche, wobei das Bestrahlungssystem eine Strahlungsquelle (1) und ein Beleuchtungssystem (3) mit strahlformenden optischen Elementen aufweist, wobei die Strahlmaskierungsmittel (7) strahlmaskierende Blenden aufweisen, die in dem oder relativ zur Fortpflanzungsrichtung des Projektionsstrahls stromab des Beleuchtungssystems angeordnet sind.

13. Ein lithografischer Projektionsapparat nach Anspruch 12, weiterhin mit einem Verschluss (4), der zwischen der Strahlungsquelle und dem Beleuchtungssystem angeordnet ist, um den Projektionsstrahl selektiv durchzulassen oder zu unterbrechen.

14. Ein Verfahren zur Herstellung einer Vorrichtung, mit den Schritten von:
Bereitstellen eines Substrats, welches zumindest teilweise mit einer Schicht eines energieempfindlichen Materials bedeckt ist;
Bereitstellen einer Maske, die ein Muster enthält;
Verwenden eines Projektionsstrahls einer Strahlung, um ein Bild von wenigstens einem Teil des Maskenmusters auf einen Zielbereich der Schicht aus energieempfindlichem Material mit einer Vergrößerung M zu projizieren;
Bewegen der Maske während des Projektionsschrittes in eine Abtastrichtung relativ zu dem Projektionsstrahl; und
Bewegen des Substrats während des Projektionsschrittes entlang der Abtastrichtung mit einer Rate gleich dem M-fachen der Rate, mit der die Maske bewegt wird; und
Bereitstellen von Strahlmaskierungsmitteln, welche vor dem Projektionsschritt geschlossen und zu dessen Beginn geöffnet werden, **gekennzeichnet durch**:
Kompensieren von Änderungen in der Strahlungsintensität des Projektionsstrahls auf der Maske, während sich die Strahlmaskierungsmittel öffnen.

## Revendications

1. Appareil de projection lithographique comportant :
un système de rayonnement (2, 3) pour fournir un faisceau de projection (PB) de rayonnement sur un masque (MA) ayant un motif, ledit système de rayonnement étant adapté pour fournir un faisceau de projection dont la section transversale dans le plan du masque est plus petite que le motif de masque, le système de rayonnement comportant des moyens de masquage de faisceau mobiles (7) pour commander la section transversale du faisceau de projection ;
une première table d'objet mobile dans une première direction et munie d'un support de masque (MH) pour supporter le masque ayant le motif de masque ;
une seconde table d'objet mobile dans la première direction et munie d'un support de substrat (WH) pour supporter un substrat ;
un système de projection (PL) pour reproduire une partie irradiée du masque sur une partie cible du substrat avec un grossissement M ; et
des moyens de commande (1) pour amener les moyens de masquage de faisceau à être fermés avant le début d'un balayage et à s'ouvrir au moment du début d'un balayage ; **caractérisé par** :
des moyens de compensation (10, 9) pour compenser une variation d'intensité de rayonnement du faisceau de projection sur le masque pendant que les moyens de masquage de faisceau s'ouvrent.

2. Appareil de projection lithographique selon la revendication 1, dans lequel lesdits moyens de compensation comportent des moyens de commande de source de rayonnement (10, 9) adaptés pour commander la sortie d'une source de rayonnement (1) utilisée pour produire le faisceau de projection, conformément au degré d'ouverture des moyens de masquage de faisceau (7), pour compenser ladite variation.

3. Appareil de projection lithographique selon la revendication 2, dans lequel ladite variation est une augmentation et lesdits moyens de commande de source de rayonnement (10, 9) sont adaptés pour réduire la sortie de la source de rayonnement alors que les moyens de masquage de faisceau s'ouvrent.

4. Appareil de projection lithographique selon la revendication 3, dans lequel lesdits moyens de commande de source de rayonnement (10, 9) sont adaptés pour commander la sortie de la source de rayonnement pour suivre une fonction linéaire de X réciproque, où X est la proportion cachée de la section transversale d'une fente définie par les moyens de masquage de faisceau (7).

5. Appareil de projection lithographique selon la revendication 2, 3 ou 4, dans lequel lesdits moyens de commande de source de rayonnement (10,9) sont adaptés pour commander la sortie de la source de rayonnement conformément à une fonction déterminée par :
la section transversale du faisceau de projection lorsque les moyens de masquage de faisceau (7) sont entièrement ouverts, et
la dimension du motif de réticule à reproduire.

6. Appareil de projection lithographique selon la revendication 5, dans lequel ladite fonction est calculée à partir de valeurs de référence obtenues empiriquement.

7. Appareil de projection lithographique selon l'une quelconque des revendications précédentes, dans lequel lesdits moyens de compensation sont tels que les moyens de masquage de faisceau (70) sont construits d'un matériau sensiblement transparent audit faisceau de projection et sont réalisés de telle sorte que des parties dudit faisceau de projection venant frapper sur ceux-ci subissent une réflexion interne totale.

8. Appareil de projection lithographique selon l'une quelconque des revendications précédentes, dans lequel lesdits moyens de compensation comportent un revêtement réflecteur (72) agencé sur la surface arrière desdits moyens de masquage de faisceau (70) par rapport à la direction d'incidence du faisceau de projection.

9. Appareil de projection lithographique selon la revendication 8, dans laquelle ladite surface arrière desdits moyens de masquage de faisceau (70) inclut une partie inclinée (70C) adjacente à un bord (70D) de celle-ci.

10. Appareil de projection lithographique selon la revendication 8 ou 9, dans lequel ledit revêtement réflecteur (72) est constitué d'aluminium.

11. Appareil de projection lithographique selon l'une quelconque des revendications 7 à 10, dans lequel ledit matériau sensiblement transparent audit faisceau de projection est constitué de quartz ou de verre.

12. Appareil de projection lithographique selon l'une quelconque des revendications précédentes, dans lequel ledit système de rayonnement comporte une source de rayonnement (1) et un système d'éclairage (3) comportant des éléments optiques de mise en forme de faisceau, lesdits moyens de masquage de faisceau (7) comportant des lames de masquage de faisceau agencées dans la direction de propagation dudit faisceau de projection dudit système d'éclairage ou en aval par rapport à celle-ci.

13. Appareil de projection lithographique selon la revendication 12, comportant de plus un obturateur (4) agencé entre ladite source de rayonnement et ledit système d'éclairage pour laisser passer et bloquer sélectivement ledit faisceau de projection.

14. Procédé de fabrication d'un dispositif comportant les étapes consistant à :
fournir un substrat qui est au moins partiellement recouvert d'une couche de matériau sensible à une énergie ;
fournir un masque contenant un motif ;
utiliser un faisceau de projection de rayonnement pour projeter une image d'au moins une partie du motif de masque sur une zone cible de la couche de matériau sensible à une énergie avec un grossissement M ;
déplacer le masque pendant ladite étape de projection dans une direction de balayage par rapport audit faisceau de projection ; et
déplacer le substrat pendant ladite étape de projection le long de ladite direction de balayage à une vitesse égale à M fois la vitesse à laquelle le masque est déplacé ; et
fournir des moyens de masquage de faisceau qui sont fermés avant le début de ladite étape de projection et ouverts au début de celle-ci ; **caractérisé par** :
une compensation d'une variation d'intensité de rayonnement du faisceau de projection sur le masque pendant que les moyens de masquage de faisceau s'ouvrent.
